# EUROPEAN PATENT SPECIFICATION

(11) **EP 2 948 337 B1**
(45) Date of publication and mention of the grant of the patent: **04.03.2020**
(21) Application number: 14702419.4
(22) Date of filing: 21.01.2014
(51) Int. Cl.: B60L 58/12

(54) **ADAPTIVE AVAILABLE POWER ESTIMATION FOR HIGH VOLTAGE LITHIUM ION BATTERY**
ADAPTIVE MESSUNG DER VERFÜGBAREN LEISTUNG EINER LITHIUM-IONEN-HOCHSPANNUNGSBATTERIE
ESTIMATION D'ÉNERGIE DISPONIBLE ADAPTATIVE DESTINÉE À UNE BATTERIE LITHIUM-ION HAUTE TENSION

(30) Priority: 25.01.2013 US 201313750860
(43) Date of publication of application: 02.12.2015
(73) Proprietor: Cummins Inc., Columbus, IN 47201 (US)
(72) Inventor: ZHOU, Lining, Columbus, Indiana 47201 (US); BOOKS, Martin T., Columbus, Indiana 47201 (US)
(74) Representative: Roberts, Peter David
(86) International application number: PCT/US2014/012320
(87) International publication number: WO 2014/116583

(56) References cited:
- EP-A2- 1 798 100
- FR-A1- 2 894 728
- US-A1- 2005 077 867
- US-A1- 2006 022 642
- US-A1- 2006 152 196
- US-A1- 2007 029 119
- US-A1- 2012 208 672
- US-B1- 7 541 756

## Description

### FIELD OF INVENTION

The present invention is generally directed to the field of batteries and more particularly to estimation techniques of available power of a battery in relation to external power commands.

### BACKGROUND OF THE INVENTION

A battery's life is dependent upon the proper charging and discharging of cells within a battery, in relation to the loads and demands that are placed on a battery in operation. For instance, a High Voltage (HV) Lithium-Ion (Li-Ion) battery is comprised of cells which can be charged and discharged to an extent where the Li-Ion battery is viewed as a better performer in retaining charge and not discharging as substantially as other battery types.

In operation, a Li-Ion battery's performance is directly related to its cell voltage, which is also one of the principally changing characteristics of the battery. The dynamics of battery cell voltage is directly influenced by battery current as is generally familiar under Ohms law with certain degree of uncertainty in the cell impedance model. The cell voltage of a battery typically has a working boundary during the battery operations, which the battery is anticipated to operate within. However, as the load on the battery may change instantaneously, the voltage may change dynamically with the instantaneous current charge or discharge. As a result, the working boundaries of the voltage of the battery may be exceeded in relation to the load.

In a hybrid engine operation that involves a battery arranged with an engine where the engine may act to charge the battery and one or both of the battery and engine may act to power a connected drivetrain or chassis, ensuring that the battery is accurately charged or discharged while it is operative within its desired working boundaries is important. For, in the above example, where the battery has estimated an amount of available power and the load on the battery creates a demand that causes the battery to exceed it working boundaries (in other words, available power, for example), the hybrid solution will not efficiently benefit from the battery's operation.

In operation today, as a battery's operation is often related to its state of charge (SOC) and the temperature at which it is operating, look-up tables provide information about a battery and its available power in relation to the SOC and the cell temperature. While this approach provides information of available power of the battery that may be of interest in certain situations, the information determined does not account for transient periods and does not provide information that benefits the performance of a hybrid system. One example is US 2006/0022642.

For instance, both the SOC and the cell temperature of a battery are lagging indicators of a present state of the battery, where even using the look-up tables, the resulting information is generally historical and not instantaneous. Similarly, during transient periods, where there may be a sudden demand or surge for power, the look-up table in effect acts to limit power as a fast transient variable, such that the look-up table calculations are lagging in actual transient power demand changes and needs. In the latter situation, where the look-up table is unable to maintain or "catch up" with the transient changes to power, the cell voltage of the battery will exceed its working boundary resulting in an open battery contactor and cessation electrical operation of a hybrid system, for instance. Similarly, for a battery system (e.g., hybrid engine, batteries, system having power from at least a single battery in part, etc.) where the determination of the power available from the system is inaccurate, when the power limit is reached by a load applied to the battery system, there is a risk of the system limit being exceeded or an overvoltage occurring which may be mission disabling.

What is needed is an approach which may adaptively determine available power as an operating limit of the battery in relation to a cell voltage reading, where the available power can be adjusted and the cell voltage may be regulated over a predetermined working boundary range for minimal over-shoot.

### SUMMARY OF THE INVENTION

The present invention provides a method for estimating battery available power from a battery system in relation to a cell voltage, the method comprising: receiving a power command for the battery system; determining a cell voltage of a battery in the battery system; providing a cell voltage threshold to a feedforward estimator and to a proportional-integral-derivative (PID) feedback compensator; providing the determined cell voltage to the PID feedback compensator; determining, by the PID feedback compensator, a feedback power limit based on the cell voltage threshold and the cell voltage; determining, by the feedforward estimator, a feedforward power limit based on the cell voltage threshold; determining a power adjustment for the battery responsive to the feedforward power limit and the feedback power limit; and generating a final power command based on the power adjustment for the battery and the power command.
There is also described a method for estimating available power from a battery system in relation to a cell voltage, comprising: determining the cell voltage, power command of the battery system; and a cell voltage threshold. The method also includes calculating a power adjustment in relation to the cell voltage and the cell voltage threshold and generating a final power command in relation to the power command and the calculated power adjustment. In one or more preferred embodiments, the step of calculating the power adjustment includes, using a regulator to determine a power limit feedback.

The present invention further provides a system for estimating battery available power from a battery system in relation to a cell voltage, the system comprising: at least one sensor capable of determining cell voltage of a battery source at a specific time; at least one data sensor operatively coupled to detect at least one or more data inputs of characteristics of a device; a control system for the device and the battery source; and, a data processor connected with the at least one data sensor for determining the cell voltage and a system power command for the battery source, wherein the data processor includes a feedforward estimator and a proportional-integral-derivative (PID) feedback compensator, wherein the data processor is further structured to: determine a cell voltage threshold; determine, by the PID feedback compensator, a feedback power limit based on the cell voltage threshold and the cell voltage; determine, by the feedforward estimator, a feedforward power limit based on the cell voltage threshold; determine a power adjustment for the battery source responsive to the feedforward power limit and the feedback power limit; and generate a final power command for the battery source based on the determined power adjustment and the system power command.
There is also described a system for estimating battery available power from a battery system in relation to a cell voltage, in combination with an engine having a battery power source. The system includes the engine including a communication with the battery power source to receive power therefrom and to provide power thereto for charging and discharging; at least one sensor capable of determining cell voltage of the battery source at a specific time; and, at least one data sensor operatively coupled to detect at least one or more data inputs of engine characteristics of the engine.

Preferably the system further includes a control system for the engine and the battery source; and, a data processor connected with the at least one data sensor for determining the cell voltage and a system power command of the battery source; determining a cell voltage threshold; calculating a power adjustment in relation to the cell voltage and the cell voltage threshold; and generating a final power command for the battery source.

A further embodiment of the present invention includes a computer program product stored on a computer usable medium for estimating battery available power from a battery system in relation to a cell voltage, comprising, a computer readable program for causing a computer to control an execution of an application within a memory control device in operable communications with a device; the computer readable program being executable by a computer to perform operations, comprising: determining a cell voltage and a power command of a battery system; determining a cell voltage threshold of a battery in the battery system; determining, by a proportional-integral-derivative (PID) feedback compensator, a feedback power limit based on the cell voltage threshold and the cell voltage; determining, by a feedforward estimator, a feedforward power limit based on the cell voltage threshold; determining a power adjustment for the battery responsive to the feedforward power limit and the feedback power limit; and generating a final power command for the battery based on the determined power adjustment and the power command.
There is further described a computer program product stored on a computer usable medium for estimating battery available power from a battery system in relation to a cell voltage. The program product includes a computer readable program for causing a computer to control an execution of an application within a memory control device in operable communications with an engine. Preferably the computer readable program when executed by a computer for: determining the cell voltage and a power command; determining a cell voltage threshold; and calculating a power adjustment in relation to the cell voltage and the cell voltage threshold for adaptively regulating the cell voltage. The program product also generates a final available power in relation to the estimated battery available power, the power command and the calculated power adjustment.

Further embodiments, forms, objects, features, advantages, aspects, and benefits of the present application shall become apparent from the detailed description and drawings included herein.

### BRIEF DESCRIPTION OF THE DRAWINGS

Figure 1 is an illustration of a block diagram of one form of the control system of the present invention in accordance with an embodiment of the present invention;
Figure 2 is a block diagram of a method of the present invention in accordance with one or more embodiments thereof;
Figure 3 sets forth a block diagram hierarchy of the active or inactive operation of the integrator and anti-windup processing of the present invention in accordance with one or more preferred embodiments; and,
Figure 4 sets forth a flowchart of the present invention in accordance with one embodiment.

### DETAILED DESCRIPTION OF THE ILLUSTRATIVE EMBODIMENTS

The following description is presented to enable one of ordinary skill in the art to make and use the invention and is provided in the context of a patent application and its requirements. Various modifications to the preferred embodiments and the generic principles and features described herein will be readily apparent to those skilled in the art. Thus, the present invention is not intended to be limited to the embodiments shown, but is to be accorded the widest scope consistent with the principles and features described herein.

For the purposes of promoting an understanding of the principles of the invention, reference will now be made to the embodiments illustrated in the drawings and specific language will be used to describe the same. It will nevertheless be understood that no limitation of the scope of the invention is thereby intended, such alterations, modifications, and further applications of the principles of the present invention as illustrated herein being contemplated as would normally occur to one skilled in the art to which the invention relates.

The present invention provides for a method, control system, computer program product providing a method for estimating battery available power from a battery system in relation to a cell voltage, over known approaches, and is applicable for many applications including internal combustion and hybrid engines.

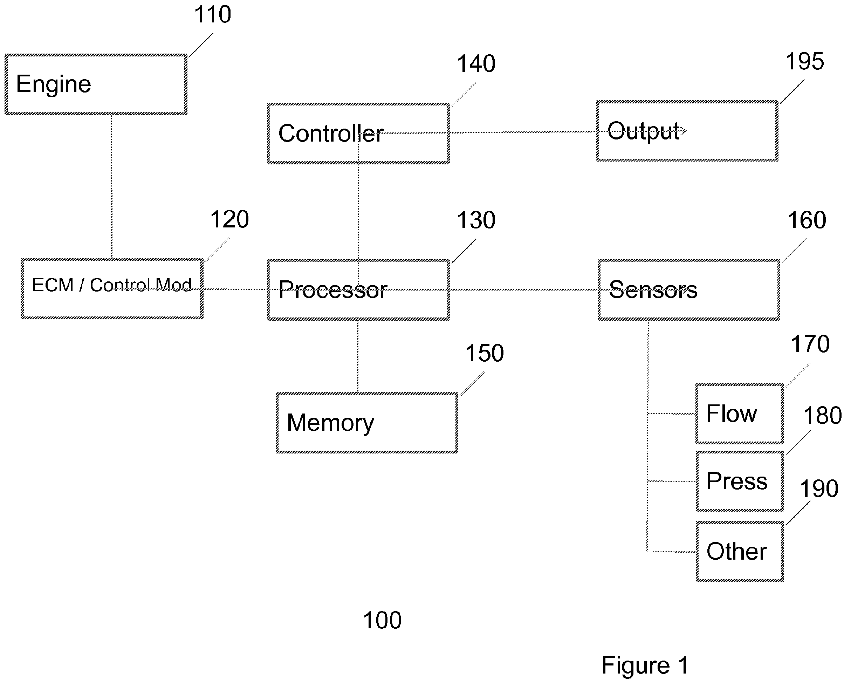

Figure 1 is an illustration of a block diagram of one form of the control system 100 of the present invention in accordance with an embodiment of the present invention.

In Figure 1, an internal combustion engine, battery or energy source 110 is in communication with a control module such as an engine control module (ECM) 120 which provides control information for the operation of the engine, battery or other component, such as voltage, current and power. The term ECM herein is used as an exemplar and is not intended to be limiting to the scope of the invention. The ECM 120 is in communication with a processor 130 of the control system which is in communication with a controller 140 for controlling the operation of the present invention, though other configurations are also envisioned by the present invention. System memory 150 is associated with the system processor 130 and may retain information associated with the operation and activities of the present invention. Sensor(s) for measuring and receiving information from measured sources associated with the engine operation is located at 160 and is in communication with the system processor 130 and controller 140. In one or more preferred embodiments, a hybrid engine is at 110 wherein the power, current and/or voltage of the energy source of the system is in communication with a controller at 120.

In a preferred embodiment, actuators, not pictured, may also be associated with the sensors and may be controlled by the controller for turning on/off the measurement and gathering of data inputs of the engine operation associated with the sensors. Exemplary sensors 160 may include a battery, voltage, power and current sensors (170-190) for example.

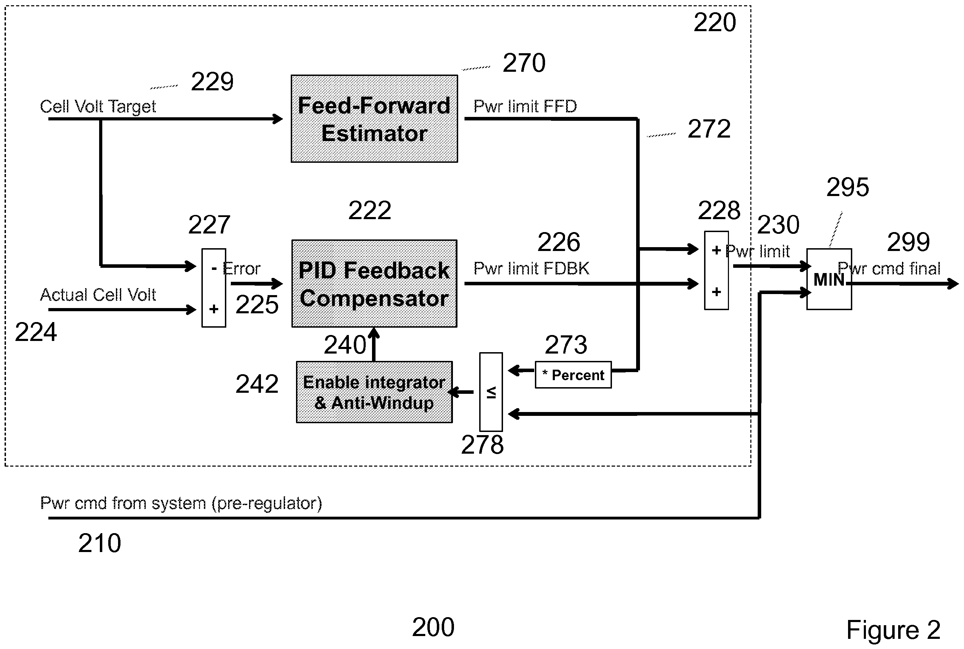

Figure 2 is a block diagram of a method 200 of the present invention in accordance with one or more embodiments thereof. From Figure 2, a method of the present invention may be segregated into two portions, a static portion 210 and a dynamic portion 220. The static portion 210 is the power command from the system which is independent of the battery capability. The power command 210 acts essentially as a demand element for the system, where the power command seeks to demand a power value for the system, irrespective of the battery capacity of the system. The power command 210 does not undergo amendment through the dynamic portion 220 in a single pass, but a final power command 299 is determined in relation to the power command 210 and the dynamic portion 220. As used herein, the term power command may also be used as system power demand, initial power demand, and similar.

The power command 210 can be measured or calculated using sensors, estimates, approximations or actual values, of which the value is then used as input with a comparator at 295 for determination of a final power command at 299 based on the lesser of the inputs of the power command 210 and the power limit 230 of the dynamic portion 220. Preferably, the power command is that power which the system requires independent of the available battery capability or power.

The dynamic portion 220 essentially sets forth a determination of the limitations of the capabilities of the current system having the battery, independent of the power command 210 from the system. The dynamic portion 220, in general, receives cell voltage 229 and actual cell voltage 224, and processes the inputs through a feed-forward estimator 270 and a proportional-integral-derivative (PID) feedback compensator (or controller) 222 to determine a power limit of the capability at 230. The power limit may also be referred to herein as a budget, capability limitation, estimated available battery power, available power limit, and similar.

Referring again to Figure 2, a cell voltage target value is set forth at 229 and is used as input to the feed forward estimator (FFE) 270 to generate a power limit from the feed forward calculation (power limit FFD) at 272. The power limit FFD 272 is essentially an initial evaluation of the power available using the estimation processing of the FFE. The determination of the power limit FFD at 272 provides a first approximation of what the power limit of the system is capable of, for example. The power limit FFD 272 is also provided as input to the comparator at 228.

Also from Figure 2, an actual cell voltage of the battery 224, determined at a predetermined period, is provided as input to a comparator at 227. A cell voltage target 229 is also provided as input to the comparator at 227. The comparator 227 determines the difference between the two inputs and defines the difference at 225 to be the cell voltage error (CVE). The CVE 225 is used as input to the PID feedback compensator 222. An adjustment of the power limit, known as the power limit feedback (power limit FDBK) 226 is output from the compensator and is used as input to the comparator at 228. Preferably, in a further embodiment, the power limit FDBK 226 is a refinement of the power limit additionally available in relation to the CVE.

At 228, the comparator is additive of the inputs resulting in an output of a power limit 230 of the dynamic portion 220. The power limit 230 reflects the initial evaluation of power available 270 and the additional amount determined from the PID compensator 222 in relation to the CVE 225. The power limit 230 is essentially a maximum power limitation of the capabilities, within 220.

The power limit 230 and the power command 210 are inputs to the comparator 295. The comparator 295 selects the lesser of the two inputs to determine a final power command (or power command final) at 299. The power command final 299 is preferably then sent as a command to a battery for a sourced power. Optimally, the present invention is situated so as to determine a final power available 230 to limit the battery power demand from the system 210 at 295 such that a final demand at 299 will not cause the battery to exceed the cell voltage threshold.

From Figure 2, a condition may arise in one or more preferred embodiments where the step of adaptively adjusting the cell voltage is active when the cell voltage approaches the cell voltage threshold, such that the power error 225 is relatively small, such that the power limit feedback 226 is also small. The power command 210 is the power that the system requires regardless of the battery condition or output capability, for operation.

Preferably, in operation, the integrator and anti-windup processing at 242 is normally in a disabled mode until or except where a power command 210 exceeds a predetermined value. The integrator and anti-windup processing at 242 is enabled at 278 when the power command 210 is equal to or exceeds the product of the power limit FFD 270 and a predetermined threshold value 273 (i.e., percentage value) at 278. As the system power demand increases in value, independent of battery conditions, the integrator and anti-windup processing at 242 is enabled at a predetermined value 273. The predetermined value 273 is preferably defined as a predetermined percentage of the power limit FFD determination at 272 in comparison to the power command 210, such that the product of the percentage threshold multiplied by the power limit feed forward value enables the integrator and anti-windup processing to operate at a certain threshold calculation at 278 where the power command is equal to or exceeds the product calculation, and causes such to not be operative at 278 when the power command 210 is less than the product calculation at 278. In a preferred embodiment, where the power command 210 is greater than the power limit FFD multiplied by the percentage threshold, the integrator and anti-windup of 242 is enabled and the PID 222 is active to integrate up to the anti-windup limit at 240, and if the power command is not greater than the threshold calculation, then the integrator and wind-up of 242 is not enabled such that the PID is set to zero at 240.

Further from Figure 2, by example, where the power command 210 were to have a value of 40kW and the determined power limit 230 were to have a value of 50kW, the power command final determination at 299 would be the lesser of the two inputs, or the 40kW value.

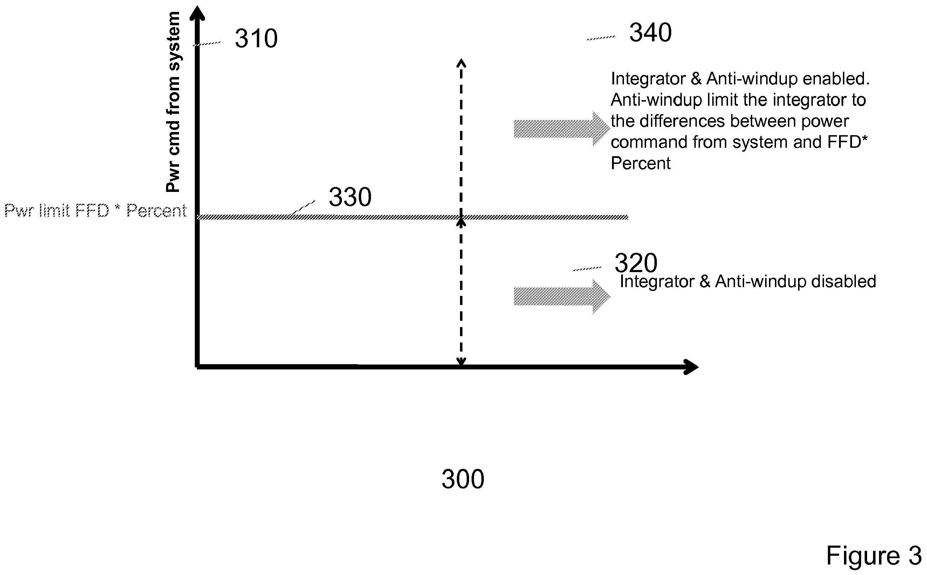

Figure 3 sets forth a block diagram 300 hierarchy of the active or inactive operation of the integrator and anti-windup processing of the present invention in accordance with one or more preferred embodiments. From Figure 3, as the power command from the battery system increases in value along axis 310, the integrator and anti-windup processing is disabled at 320 when at or below a predetermined value 330. The predetermined value 330 is preferably defined as a percentage of the power limit feed forward determination; such that the product of the percentage threshold multiplied by the power limit feed forward value determines the threshold 330. When the power command is equal to or greater than the product of the predetermined percentage threshold multiplied by the power limit feed forward, the integrator and anti-windup processing are operative at 340.

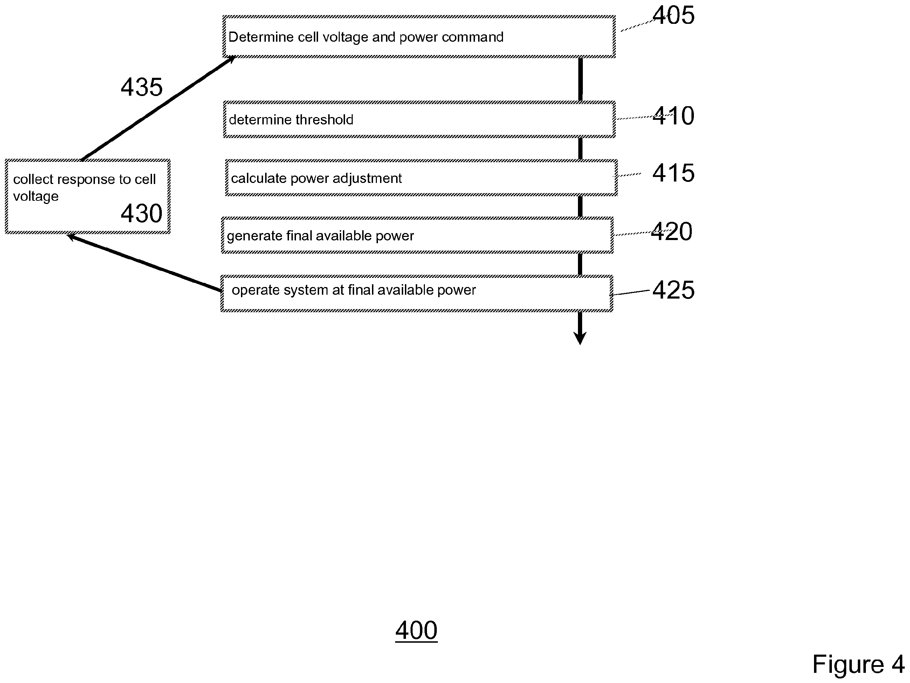

Figure 4 sets forth a flowchart of the present invention 400 in accordance with one embodiment. From Figure 4, a method for estimating battery available power from a battery system in relation to a cell voltage is set forth, where at 405 a cell voltage and a power command of the battery system is determined. At 410, a cell voltage threshold is determined. Calculating a power adjustment in relation to the cell voltage and the cell voltage threshold is set forth at 415. At 420, a final available power command associating the estimated battery available power with the power command and the calculated power adjustment is generated. At 425, the system is able to operate at the final available power command (also used herein as final power command or final power). Optionally, for a next cycle input, a response to the cell voltage may be collected at 430 and used as input for a following cycle at 435.

In one or more embodiments, the present invention may be used as computer software, firmware or as a simulation model, for example. In operation as a simulation model, the present invention includes a battery limit regulator which receives inputs of high cell voltage, high cell volt target, derivative gain, proportional gain, current gain, and one or more other battery power characteristics such as range of operation, voltage windows, time, etc. The high cell voltage input to the regulator may include that output of a prior operation run in which the simulation produced an actual cell voltage determination or estimation. Output of the regulator is a power limit for the battery which is then compared with the power command signal from the battery system, wherein the maximum value of the compared result is used as input power available to the battery. The battery also has operating range inputs, minimum and maximum operating ranges, where the cell volt output of the battery is determined thereafter. The cell volt output is compared with noise limits and the actual cell voltage value is determined. As a result, by using the present invention, power error can be controlled thereby reducing the error over time of the operation with a battery system through feedback, such that the voltage, power and current of the battery system are used efficiency and effectively.

In one or more embodiments, a controller of the present invention is preferably an electronic control unit comprised of a digital computer, which may include a programmable computer product of the present invention for instance, and include components connected with and in communication with one another through a back bone circuit or other bidirectional bus such as a ROM (read only memory), RAM (random access memory), CPU (microprocessor), input port, and output port, by example. The present invention may also be a circuit, application, software or other electronic means within a controller or separate and in communication with the controller as well.

In a further embodiment of the present invention, a method of monitoring and determining available power estimation for a battery in combination with one or more sensed engine characteristics is envisioned.

Advantageously, the method of the present invention eliminates the need to use look-up tables and other lagging indicators, to yield a reliable method for estimating power available for a battery system. Further, advantageously, the present invention may be used in any system, device or method that requires a battery in operation, where the present invention may act to protect the battery in the system by using the dynamic adjustment. In one or more preferred embodiments, the cell voltage is regulated at a target or within a target range.

It will be appreciated by those skilled in the art that there are many variations to the steps above that may be undertaken or altered while remaining within the scope of the present invention.

Any theory, mechanism of operation, proof, or finding stated herein is meant to further enhance understanding of the present invention and is not intended to make the present invention in any way dependent upon such theory, mechanism of operation, proof, or finding. It should be understood that while the use of the word preferable, preferably or preferred in the description above indicates that the feature so described may be more desirable, it nonetheless may not be necessary and embodiments lacking the same may be contemplated as within the scope of the invention, that scope being defined by the claims that follow.

The system described herein provides for a method for estimating battery available power from a battery system in relation to a cell voltage. By doing so, the present invention provides a system and method to reduce costs to battery damage, increases engine and associated load performances, and effectively provides for improved energy management in various operating systems.

While the invention has been described with reference to the aforementioned embodiments, it should be appreciated by those skilled in the art that the invention may be practiced otherwise than as specifically described herein without departing from the scope of the claims. It is therefore understood that the scope of the invention be limited only by the appended claims.

The system and method described above has obvious industrial applicability including that which would be useful in any environment where a user desires to reliably deploy battery systems requiring varying loads and/or hybrid engine systems, such as with, but not limited to stationary power sources and vehicle engines.

## Claims

1. A method for estimating battery available power from a battery system in relation to a cell voltage, comprising:
receiving a power command (210) for the battery system;
determining a cell voltage of a battery in the battery system;
providing a cell voltage threshold to a feedforward estimator (270) and to a proportional-integral-derivative (PID) feedback compensator (222);
providing the determined cell voltage to the PID feedback compensator;
determining, by the PID feedback compensator, a feedback power limit based on the cell voltage threshold and the cell voltage;
determining, by the feedforward estimator, a feedforward power limit based on the cell voltage threshold;
determining a power adjustment for the battery responsive to the feedforward power limit and the feedback power limit; and
generating a final power command (299) for the battery based on the power adjustment for the battery and the power command.

2. The method of claim 1, wherein the power command is determined in relation to a specific time.

3. The method of claim 2, wherein the power command is determined instantaneously.

4. The method of claim 1, wherein the step of determining the power adjustment further includes using an integrator with an anti-windup feature to provide a means for limiting the feedback power limit from the PID feedback compensator.

5. The method of claim 1, further comprising operating at a final available power corresponding to the final power command, wherein the step of generating the final power command further includes relating the feedback power limit and the power command to yield the final available power.

6. The method of claim 5, further comprising adaptively adjusting the cell voltage of the battery system in relation to the final power command associated with the generated final available power.

7. The method of claim 6, wherein the cell voltage is regulated to operate within a predefined working boundary; wherein optionally the predefined working boundary of the cell voltage is +/-1 volt of the cell voltage.

8. The method of claim 6, wherein the step of adaptively adjusting the cell voltage includes enabling an integrator and anti-windup processor where the power command is greater than or equal to a product of the feedforward power limit and a predetermined enabling threshold; or
wherein the step of adaptively adjusting the cell voltage includes disabling an integrator and anti-windup processor where the power command is less than a product of the feedforward power limit and a predetermined enabling threshold.

9. A system for estimating battery available power from a battery system in relation to a cell voltage, comprising:
at least one sensor determining cell voltage of a battery source at a specific time;
at least one data sensor operatively coupled to detect at least one or more data inputs of characteristics of a device;
a control system for the device and the battery source; and,
a data processor connected with the at least one data sensor for determining the cell voltage and a system power command for the battery source, wherein the data processor includes a feedforward estimator (270) and a proportional-integral-derivative (PID) feedback compensator (222), wherein the data processor is further structured to:
determine a cell voltage threshold;
determine, by the PID feedback compensator, a feedback power limit based on the cell voltage threshold and the cell voltage;
determine, by the feedforward estimator, a feedforward power limit based on the cell voltage threshold;
determine a power adjustment for the battery source responsive to the feedforward power limit and the feedback power limit; and
generate a final power command (299) for the battery source based on the determined power adjustment and the system power command.

10. The system of claim 9, wherein the system is configured to operate at a final available power corresponding to the final power command, wherein the system is configured to generate the final power command by selecting the lesser of the sum of the feedback power limit and the feedforward power limit, and the system power command to yield the final power command.

11. The system of claim 10, wherein the system is configured to adaptively adjust the cell voltage of the battery source in relation to the final power command.

12. The system of claim 11, wherein the system is configured to adaptively adjust the cell voltage when the system power command is greater than or equal to a product of the feedforward power limit and a predetermined enabling threshold.

13. A computer program product stored on a computer usable medium for estimating battery available power from a battery system in relation to a cell voltage, comprising, a computer readable program for causing a computer to control an execution of an application within a memory control device in operable communications with a device; the computer readable program product being executable by a computer to perform operations, comprising:
determining a cell voltage and a power command of a battery system;
determining a cell voltage threshold of a battery in the battery system;
determining, by a proportional-integral-derivative (PID) feedback compensator (222), a feedback power limit based on the cell voltage threshold and the cell voltage;
determining, by a feedforward estimator (270), a feedforward power limit based on the cell voltage threshold;
determining a power adjustment for the battery responsive to the feedforward power limit and the feedback power limit; and
generating a final power command (299) for the battery based on the determined power adjustment and the power command.

14. The product of claim 13, wherein the operations are for one or more of an internal combustion engine having a battery-based power source or supplemental power source, a hybrid engine, a battery-powered power source, and a battery-based engine having one or more supplemental power sources.

15. The product of claim 14, wherein the operations further comprise operating the battery at the final power command, wherein the operation of generating the final power command further includes an operation of selecting the lesser of a sum of the feedback power limit and the feedforward power limit and the power command to yield the final power command.

## Patentansprüche

1. Verfahren zum Schätzen einer verfügbaren Batterieleistung von einem Batteriesystem in Bezug auf eine Zellenspannung, umfassend:
Empfangen eines Leistungsbefehls (210) für das Batteriesystem;
Bestimmen einer Zellenspannung einer Batterie in dem Batteriesystem;
Bereitstellen eines Zellenspannungsschwellenwerts für einen Vorwärtskopplungsschätzer (270) und einen Proportional-Integral-Derivative (PID) - Rückkopplungskompensator (222);
Bereitstellen der bestimmten Zellenspannung an den PID-Rückkopplungskompensator;
Bestimmen einer Rückkopplungsleistungsgrenze durch den PID-Rückkopplungskompensator basierend auf der Zellenspannungsschwellenwert und der Zellenspannung;
Bestimmen einer Vorwärtskopplungsleistungsgrenze durch den Vorwärtskopplungsschätzer basierend auf dem Zellenspannungsschwellenwert;
Bestimmen einer Leistungsanpassung für die Batterie als Reaktion auf die Vorwärtskopplungsleistungsgrenze und die Rückkopplungsleistungsgrenze; und
Erzeugen eines endgültigen Leistungsbefehls (299) für die Batterie basierend auf der Leistungsanpassung für die Batterie und den Leistungsbefehl.

2. Verfahren nach Anspruch 1, wobei der Leistungsbefehl in Bezug auf eine spezifische Zeit bestimmt wird.

3. Verfahren nach Anspruch 2, wobei der Leistungsbefehl sofort bestimmt wird.

4. Verfahren nach Anspruch 1, wobei der Schritt des Bestimmens der Leistungsanpassung ferner Verwenden eines Integrators mit einem Anti-Aufwickel-Merkmal beinhaltet, um ein Mittel zum Begrenzen der Rückkopplungsleistungsgrenze von dem PID-Rückkopplungskompensator bereitzustellen.

5. Verfahren nach Anspruch 1, ferner umfassend Betreiben mit einer endgültigen verfügbaren Leistung, die dem endgültigen Leistungsbefehl entspricht, wobei der Schritt des Erzeugens des endgültigen Leistungsbefehls ferner das Beziehen der Rückkopplungsleistungsgrenze und des Leistungsbefehls beinhaltet, um die endgültige verfügbare Leistung zu ergeben.

6. Verfahren nach Anspruch 5, ferner umfassend adaptives Anpassen der Zellenspannung des Batteriesystems in Bezug auf den endgültigen Leistungsbefehl, der der erzeugten endgültigen verfügbaren Leistung zugeordnet ist.

7. Verfahren nach Anspruch 6, wobei die Zellenspannung reguliert wird, um innerhalb einer vordefinierten Arbeitsgrenze zu arbeiten; wobei optional die vordefinierte Arbeitsgrenze der Zellenspannung +/-1 Volt der Zellenspannung ist.

8. Verfahren nach Anspruch 6, wobei der Schritt des adaptiven Anpassens der Zellenspannung Aktivieren eines Integrators und eines Anti-Aufwickel-Prozessors umfasst, wobei der Leistungsbefehl größer oder gleich einem Produkt der Vorwärtskopplungsleistungsgrenze und einem vorbestimmten Aktivierungsschwellenwert ist; oder
wobei der Schritt des adaptiven Anpassens der Zellenspannung Deaktivieren eines Integrators und eines Anti-Aufwickel-Prozessors umfasst, wobei der Leistungsbefehl kleiner als ein Produkt der Vorwärtskopplungsleistungsgrenze und einem vorbestimmten Aktivierungsschwellenwert ist.

9. System zum Schätzen der verfügbaren Batterieleistung von einem Batteriesystem in Bezug auf eine Zellenspannung, umfassend:
mindestens einen Sensor, der die Zellenspannung einer Batteriequelle zu einem spezifischen Zeitpunkt bestimmt;
mindestens einen Datensensor, der betrieblich gekoppelt ist, um mindestens einen oder mehrere Dateneingaben von Eigenschaften einer Vorrichtung zu erfassen;
ein Steuersystem für die Vorrichtung und die Batteriequelle; und,
einen Datenprozessor, der mit dem mindestens einen Datensensor verbunden ist, um die Zellenspannung und einen Systemleistungsbefehl für die Batteriequelle zu bestimmen, wobei der Datenprozessor einen Vorwärtskopplungsschätzer (270) und einen Proportional-Integral-Derivative (PID) -Rückkopplungskompensator (222) beinhaltet,
wobei der Datenprozessor weiter strukturiert ist, um:
einen Zellenspannungsschwellenwert zu bestimmen;
eine Rückkopplungsleistungsgrenze durch den PID-Rückkopplungskompensator basierend auf der Zellenspannungsschwellenwert und der Zellenspannung zu bestimmen;
eine Vorwärtskopplungsleistungsgrenze durch den Vorwärtskopplungsschätzer basierend auf dem Zellenspannungsschwellenwert zu bestimmen;
eine Leistungsanpassung für die Batteriequelle als Reaktion auf die Vorwärtskopplungsleistungsgrenze und die Rückkopplungsleistungsgrenze zu bestimmen; und
einen endgültigen Leistungsbefehl (299) für die Batteriequelle basierend auf der bestimmten Leistungsanpassung und den Systemleistungsbefehl zu erzeugen.

10. System nach Anspruch 9, wobei das System konfiguriert ist, um mit einer endgültigen verfügbaren Leistung zu arbeiten, die dem endgültigen Leistungsbefehl entspricht, wobei das System konfiguriert ist, um den endgültigen Leistungsbefehl durch Auswählen des Geringeren aus der Summe der Rückkopplungsleistungsgrenze und der Vorwärtskopplungsleistungsgrenze, und dem Systemleistungsbefehl zu erzeugen, um den endgültigen Leistungsbefehl zu erhalten.

11. System nach Anspruch 10, wobei das System konfiguriert ist, um die Zellenspannung der Batteriequelle in Bezug auf den endgültigen Leistungsbefehl anzupassen.

12. System nach Anspruch 11, wobei das System konfiguriert ist, um die Zellenspannung adaptiv anzupassen, wenn der Systemleistungsbefehl größer oder gleich einem Produkt aus der Vorwärtskopplungsleistungsgrenze und einem vorbestimmten Aktivierungsschwellenwert ist.

13. Computerprogrammprodukt, das auf einem computernutzbaren Medium gespeichert ist, um die verfügbare Batterieleistung von einem Batteriesystem in Bezug auf eine Zellenspannung zu schätzen, umfassend ein computerlesbares Programm, um einen Computer zu veranlassen, eine Ausführung einer Anwendung innerhalb einer Speichersteuervorrichtung in betrieblichen Kommunikationen mit einer Vorrichtung zu steuern; wobei das computerlesbare Programmprodukt von einem Computer ausführbar ist, um Betriebe durchzuführen, umfassend:
Bestimmen einer Zellenspannung und eines Leistungsbefehls eines Batteriesystems;
Bestimmen eines Zellenspannungsschwellenwertes einer Batterie in dem Batteriesystem;
Bestimmen, durch einen Proportional-Integral-Derivative (PID) Rückkopplungskompensator (222), einer Rückkopplungsleistungsgrenze basierend auf dem Zellenspannungsschwellenwert und der Zellenspannung;
Bestimmen, durch einen Vorwärtskopplungsschätzer (270), einer Vorwärtskopplungsleistungsgrenze basierend auf dem Zellenspannungsschwellenwert;
Bestimmen einer Leistungsanpassung für die Batterie als Reaktion auf die Vorwärtskopplungsleistungsgrenze und die Rückkopplungsleistungsgrenze; und
Erzeugen eines endgültigen Leistungsbefehls (299) für die Batterie basierend auf der bestimmten Leistungsanpassung und dem Leistungsbefehl.

14. Produkt nach Anspruch 13, wobei die Betriebe für einen oder mehrere eines Verbrennungsmotors mit einer Energiequelle auf Batteriebasis oder einer zusätzlichen Energiequelle, einem Hybridmotor, einer Energiequelle auf Batteriebasis und einem Motor auf Batteriebasis mit einer oder mehr zusätzlichen Energiequellen vorgesehen sind.

15. Produkt nach Anspruch 14, wobei die Betriebe ferner Betreiben der Batterie bei dem endgültigen Leistungsbefehl umfassen, wobei der Betrieb des Erzeugens des endgültigen Leistungsbefehls ferner einen Betrieb des Auswählens des Geringeren aus einer Summe der Rückkopplungsleistungsgrenze und der Vorwärtskopplungsleistungsgrenze und dem Leistungsbefehl beinhaltet, um den endgültigen Leistungsbefehl zu ergeben.

## Revendications

1. Procédé d'estimation d'une puissance de batterie disponible à partir d'un système de batterie relativement à une tension de cellule, comprenant les étapes ci-dessous consistant à :
recevoir une instruction de puissance (210) pour le système de batterie ;
déterminer une tension de cellule d'une batterie dans le système de batterie ;
fournir un seuil de tension de cellule à un estimateur prédictif (270) et à un compensateur de rétroaction de type « proportionnelle-dérivée-intégrale » (PID) (222) ;
fournir la tension de cellule déterminée au compensateur de rétroaction de type PID ;
déterminer, par le biais du compensateur de rétroaction de type PID, une limite de puissance de rétroaction, sur la base du seuil de tension de cellule et de la tension de cellule ;
déterminer, par le biais de l'estimateur prédictif, une limite de puissance prédictive sur la base du seuil de tension de cellule ;
déterminer un ajustement de puissance pour la batterie en réponse à la limite de puissance prédictive et à la limite de puissance de rétroaction ; et
générer une instruction de puissance finale (299) pour la batterie, sur la base de l'ajustement de puissance pour la batterie et de l'instruction de puissance.

2. Procédé selon la revendication 1, dans lequel l'instruction de puissance est déterminée relativement à un instant spécifique.

3. Procédé selon la revendication 2, dans lequel l'instruction de puissance est déterminée instantanément.

4. Procédé selon la revendication 1, dans lequel l'étape de détermination de l'ajustement de puissance inclut en outre l'étape consistant à utiliser un intégrateur doté d'une caractéristique d'anti-bouclage pour fournir un moyen permettant de limiter la limite de puissance de rétroaction à partir du compensateur de rétroaction de type PID.

5. Procédé selon la revendication 1, comprenant en outre l'étape consistant à fonctionner à une puissance finale disponible correspondant à l'instruction de puissance finale, dans lequel l'étape de génération de l'instruction de puissance finale inclut en outre l'étape consistant à lier la limite de puissance de rétroaction et l'instruction de puissance, en vue de produire la puissance finale disponible.

6. Procédé selon la revendication 5, comprenant en outre l'étape consistant à ajuster de façon adaptative la tension de cellule du système de batterie relativement à l'instruction de puissance finale associée à la puissance finale disponible générée.

7. Procédé selon la revendication 6, dans lequel la tension de cellule est régulée de manière à fonctionner dans une limite de travail prédéfinie, dans lequel, facultativement, la limite de travail prédéfinie de la tension de cellule correspond à +/-1 volt de la tension de cellule.

8. Procédé selon la revendication 6, dans lequel l'étape d'ajustement adaptatif de la tension de cellule inclut l'étape consistant à activer un intégrateur et un processeur anti-bouclage lorsque l'instruction de puissance est supérieure ou égale à un produit de la limite de puissance prédictive et d'un seuil d'activation prédéterminé ; ou
dans lequel l'étape d'ajustement adaptatif de la tension de cellule inclut l'étape consistant à désactiver un intégrateur et un processeur anti-bouclage lorsque l'instruction de puissance est inférieure à un produit de la limite de puissance prédictive et d'un seuil d'activation prédéterminé.

9. Système destiné à estimer une énergie disponible de batterie à partir d'un système de batterie relativement à une tension de cellule, comprenant :
au moins un capteur déterminant une tension de cellule d'une source de batterie à un instant spécifique ;
au moins un capteur de données couplé fonctionnellement pour détecter au moins une ou plusieurs entrées de données de caractéristiques d'un dispositif;
un système de commande pour le dispositif et la source de batterie ; et
un processeur de données connecté audit au moins un capteur de données pour déterminer la tension de cellule et une instruction de puissance de système pour la source de batterie, dans lequel le processeur de données inclut un estimateur prédictif (270) et un compensateur de rétroaction de type « proportionnelle-dérivée-intégrale » (PID) (222) ;
dans lequel le processeur de données est en outre structuré de manière à :
déterminer un seuil de tension de cellule ;
déterminer, par le biais du compensateur de rétroaction de type PID, une limite de puissance de rétroaction, sur la base du seuil de tension de cellule et de la tension de cellule ;
déterminer, par le biais de l'estimateur prédictif, une limite de puissance prédictive sur la base du seuil de tension de cellule ;
déterminer un ajustement de puissance pour la source de batterie, en réponse à la limite de puissance prédictive et à la limite de puissance de rétroaction ; et
générer une instruction de puissance finale (299) pour la source de batterie, sur la base de l'ajustement de puissance déterminé et de l'instruction de puissance de système.

10. Système selon la revendication 9, dans lequel le système est configuré de manière à fonctionner à une puissance finale disponible correspondant à l'instruction de puissance finale, dans lequel le système est configuré de manière à générer l'instruction de puissance finale en sélectionnant la valeur la plus petite parmi la somme de la limite de puissance de rétroaction et de la limite de puissance prédictive, et l'instruction de puissance de système, en vue de générer l'instruction de puissance finale.

11. Système selon la revendication 10, dans lequel le système est configuré de manière à ajuster de façon adaptative la tension de cellule de la source de batterie relativement à l'instruction de puissance finale.

12. Système selon la revendication 11, dans lequel le système est configuré de manière à ajuster de façon adaptative la tension de cellule lorsque l'instruction de puissance de système est supérieure ou égale à un produit de la limite de puissance prédictive et d'un seuil d'activation prédéterminé.

13. Produit-programme informatique stocké sur un support utilisable par ordinateur en vue d'estimer une énergie disponible de batterie à partir d'un système de batterie relativement à une tension de cellule, comprenant : un programme lisible par ordinateur pour amener un ordinateur à commander une exécution d'une application dans un dispositif de commande de mémoire, dans le cadre de communications fonctionnelles avec un dispositif ; le programme lisible par ordinateur étant exécutable par un ordinateur pour mettre en œuvre des opérations comprenant les étapes ci-dessous consistant à :
déterminer une tension de cellule et une instruction de puissance d'un système de batterie ;
déterminer un seuil de tension de cellule d'une batterie dans le système de batterie ;
déterminer, par le biais d'un compensateur de rétroaction de type « proportionnelle-dérivée-intégrale » (PID) (222), une limite de puissance de rétroaction sur la base du seuil de tension de cellule et de la tension de cellule ;
déterminer, par le biais d'un estimateur prédictif (270), une limite de puissance prédictive sur la base du seuil de tension de cellule ;
déterminer un ajustement de puissance pour la batterie, en réponse à la limite de puissance prédictive et à la limite de puissance de rétroaction ; et
générer une instruction de puissance finale (299) pour la batterie, sur la base de l'ajustement de puissance déterminé et de l'instruction de puissance.

14. Produit selon la revendication 13, dans lequel les opérations sont destinées à un ou plusieurs éléments parmi un moteur à combustion interne présentant une source d'énergie à base de batterie ou une source d'énergie complémentaire, un moteur hybride, une source d'énergie alimentée par batterie, et un moteur à base de batterie présentant une ou plusieurs sources d'énergie complémentaires.

15. Produit selon la revendication 14, dans lequel les opérations comprennent en outre l'exploitation de la batterie selon l'instruction de puissance finale, dans lequel l'opération de génération de l'instruction de puissance finale inclut en outre une opération consistant à sélectionner la valeur la plus petite parmi une somme de la limite de puissance de rétroaction et de la limite de puissance prédictive, et l'instruction de puissance, afin de produire l'instruction de puissance finale.
